(19) Europäisches Patentamt
European Patent Office
Office européen des brevets

(11) **EP 1 032 843 B1**

(12) **EUROPÄISCHE PATENTSCHRIFT**

(45) Veröffentlichungstag und Bekanntmachung des Hinweises auf die Patenterteilung:
**26.09.2001 Patentblatt 2001/39**

(51) Int Cl.⁷: $G01R\ 31/00$

(21) Anmeldenummer: **98963451.4**

(86) Internationale Anmeldenummer:
**PCT/EP98/07266**

(22) Anmeldetag: **13.11.1998**

(87) Internationale Veröffentlichungsnummer:
**WO 99/26075 (27.05.1999 Gazette 1999/21)**

(54) **VERFAHREN UND VORRICHTUNG ZUR MESSUNG DER ELEKTROMAGNETISCHEN VERTRÄGLICHKEIT**

METHOD AND DEVICE FOR MEASURING ELECTROMAGNETIC COMPATIBILITY

PROCEDE ET DISPOSITIF DE MESURE DE LA COMPATIBILITE ELECTROMAGNETIQUE

(84) Benannte Vertragsstaaten:
**AT BE CH CY DE DK ES FI FR GB GR IE IT LI LU MC NL PT SE**

(30) Priorität: **18.11.1997 DE 19753033**

(43) Veröffentlichungstag der Anmeldung:
**06.09.2000 Patentblatt 2000/36**

(73) Patentinhaber: **Deutsche Telekom AG 53113 Bonn (DE)**

(72) Erfinder:
• **RAUS, Axel**
  **D-48565 Steinfurt (DE)**
• **BRINKJANS, Martin**
  **D-48282 Emsdetten (DE)**

(56) Entgegenhaltungen:
**DE-U- 9 318 216**

• **MUND B: "The EMC behaviour of cables and conductors" ETZ, APRIL 1997, VDE-VERLAG, GERMANY, Bd. 118, Nr. 8-9, Seiten 30-33, XP002098003 ISSN 0948-7387**

## Beschreibung

Die Erfindung bezieht sich auf ein Verfahren der im Oberbegriff des Patentanspruchs 1, und auf eine Vorrichtung der im Oberbegriff des Patentanspruchs 2 näher bezeichneten Art. Derartige Verfahren und Vorrichtungen sind aus der Europäischen Norm ENV 50142 bekannt.

Das Meßverfahren dient zum Nachweis der Störfestigkeit gegenüber transienten Störgrößen der Impulsform 1,2/50 μs, wie sie z.B. als induzierte Spannungen oder als Restspannungen an Überspannungsableitern infolge atmosphärischer Entladungen innerhalb von Gebäuden auf Leitungen entstehen. Bei diesen Leitungen kann es sich um Netz-, Telekommunikations-, Koaxialleitungen oder aber auch um geschirmte Leitungen handeln.

Die in der ENV 50142 beschriebenen Meßverfahren für die Beeinflussung mit energiereichen Impulsen und die dort insbesondere in den Bildern 13 und 14 vorgeschlagenen Schaltungen beeinflussen die zu testende Schnittstelle über den Prüfling.

Nach diesem bekannten Verfahren muß die Kapazität des Prüflings aufgeladen werden. Dies bewirkt eine Verzögerung und Veränderung der Impulsform an der Schnittstelle. wird auch noch ein geschirmtes Kabel verwendet, fließt der gesamte Strom über die Schirmung ab.

In der Praxis der Übertragungstechnik bauen sich derartige Störimpulse auf den kilometerlangen Leitungen auf und befinden sich auch auf den Innenleitern der Schnittstellen.

Eine solche Beeinflussungsart wird bei den Schaltungen nach den erwähnten Bildern der Norm aber nur minimal durch die Kapazität der relativ kurzen Leitung erreicht. Außerdem muß bei einem solchen Verfahren der Prüfling auf Spannungspotential gebracht werden, was zu unnötigen Gefahren führt.

Mit der Erfindung sollen ein Verfahren und eine Vorrichtung angegeben werden, welche praxisnähere Meßergebnisse liefern und die Gefahren bei den Messungen verringern.

Diese Aufgabe wird mit dem im Kennzeichen des Patentanspruchs 1 aufgeführten Verfahren und der im Kennzeichen des Patentanspruchs 2 beschriebenen Vorrichtung gelöst.

Die Erfindung wird anhand der nachfolgenden Ausführungsbeispiele näher erläutert. In den zugehörigen Zeichnungen zeigen die:

Fig. 1 die Einsatzweise des Transformators,
Fig. 2 eine Darstellung der Netzspannung,
Fig. 3 eine Darstellung der Impulsspannung,
Fig. 4 eine Darstellung des Kurzschlußstromes,
Fig. 5 eine Darstellung des maximalen Impulsstromes,
Fig. 6 eine Darstellung der Grundfrequenz,
Fig. 7 den Belastungsfall Leerlauf Generator,
Fig. 8 den Belastungsfall Kurzschluß Generator,
Fig. 9 den Belastungsfall Leerlauf Transformator,
Fig. 10 den Belastungsfall Kurzschluß Transformator,
Fig. 11 einen offenen Meßaufbau zur Ermittlung der Impulsspannung,
Fig. 12 einen abgeschlossenen Meßaufbau zur Ermittlung der Impulsspannung

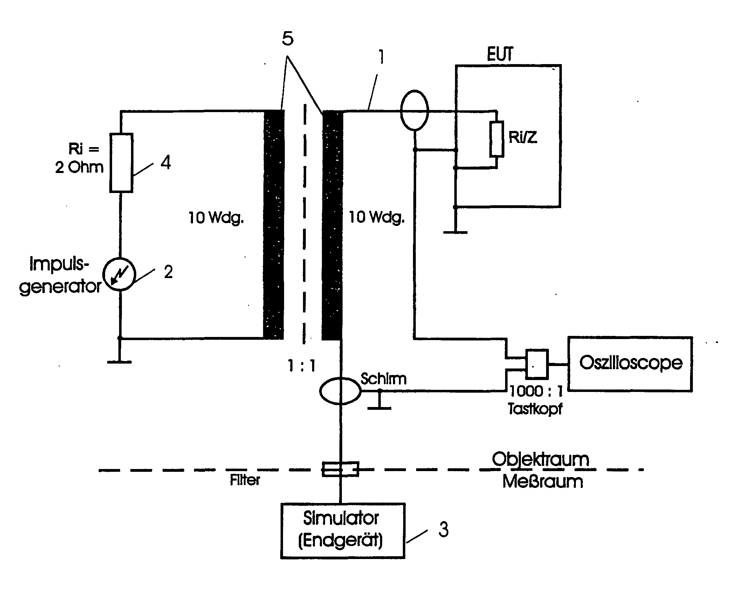

Das in diesem Beispiel vorgestellte Meßverfahren soll die Verwendung und Dimensionierung des Transformators und die Einkopplung impulsförmiger Störgrößen auf geschirmte Leitungen erläutern. Die Einsatzweise des Transformators mit dem Anschluß des Prüflings EUT ist in Fig. 1 dargestellt.

Bei der Erfindung wird davon ausgegangen, daß ein geeigneter Transformator 5 für die Einkopplung von Impulsen der Form 1,2/50 μs und einem Pegel von 1000 V ausgebildet wird.

Der Transformator 5 dient zur Einkopplung von Längsspannungsimpulsen der Form 1,2/50 μs bzw. 8/ 20 μs auf geschirmte Leitungen 1 . Gleichzeitig ermöglicht er den funktionsgerechten Anschluß des Meßobjektes an die notwendigen Simulations- oder Betreibereinrichtungen 3. Dieses hat zur Folge, daß die angeschlossenen Simulationsoder Betreibereinrichtungen, durch entsprechend große Entkopplung der Störgröße, vor Beeinflussung oder gar Zerstörung geschützt werden müssen. Durch die Kontaktierung des Schirmes mit der Bezugsmasse wird von einer genügend großen Entkopplung ausgegangen.

Zur Erläuterung des Verfahrens wird von der Wirkungsweise des Testimpulses ausgegangen.

Bei einer parallelen Verlegung von Netzleitungen und Telekommunikationsleitungen kann es zu einer galvanischen Einkopplung des Impulses 1,2/50 μs bzw. 8/ 20 μs auf den Schirm und die Innenleiter kommen. Dieses Phänomen kann mit dem Einkoppeltransformator 5 getestet werden.

Für die Berechnung der Transformatorgröße gilt folgende Verfahrensweise:

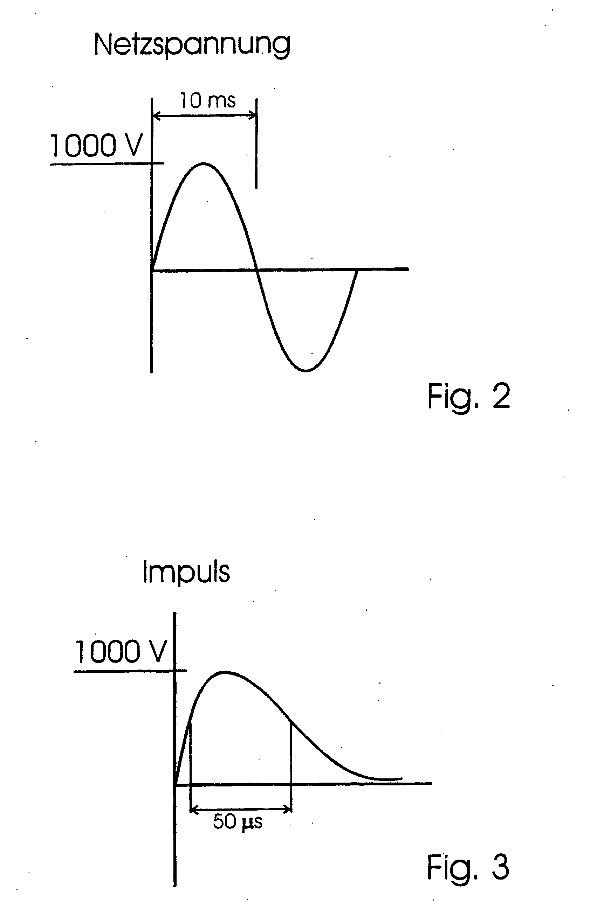

Zuerst wird für die Berechnung das Spannungs-/Zeitverhalten einer Sinuswelle der Netzspannung mit einem Pegel von 1 kV entsprechend Fig. 2 mit dem Impuls 1,2/50 μs entsprechend Fig. 3 verglichen:

Netzspannung:                                                    Impuls:

geschätzt

$$1000 \text{ V} * \int \sin\omega * dt$$

$$\Rightarrow \frac{1000V*2}{2*\Pi*50} = 6,366 \text{ Vs}$$          $$\Rightarrow \frac{1000V*100\mu s}{2} = 0,05 \text{ Vs}$$

Beim Vergleich der Berechnungen ergibt sich ein Unterschied im Spannungs-/Zeitverhältnis mit einem Faktor von 127.

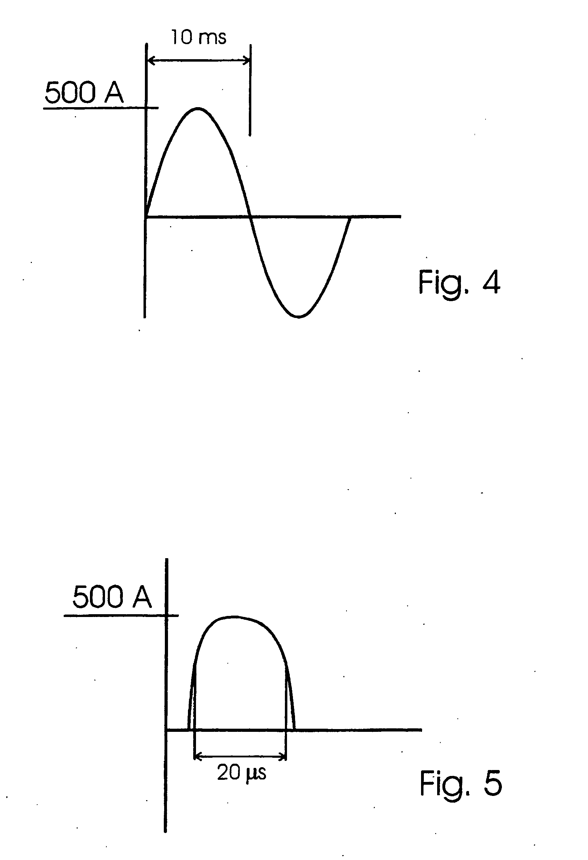

Danach erfolgt die Berechnung des Strom-/Zeitverhaltens eines maximalen Kurzschlußstromes von 500 A entsprechend Fig. 4 ( 1000 V/ Ri = 2Ω ) im Vergleich mit dem maximalen Impulsstrom entsprechend Fig. 5:

$$500 \text{ A} * \int \sin\omega * dt$$

$$\Rightarrow \frac{500A*2}{2*\Pi*50} = 3,18 \text{ As} \qquad \Rightarrow \frac{500A*50\mu s}{2} = 0,0125 \text{ As}$$

Beim Vergleich der Berechnungen ergibt sich ein Unterschied im Strom-/Zeitverhältnis mit einem Faktor von 254.

Für die Abschätzung der Transformatorgröße gilt, daß beim Betrieb eines Transformators an einer sinusförmigen Netzspannung mit einem Pegel von 1000 V und einem maximalen Strom von 500 A eine maximale Leistungsaufnahme von 500 kVA entsteht.

Da der benötigte Transformator aber nur mit kurzzeitigen Impulsen belastet wird, kann er für eine wesentlich geringere Leistung dimensioniert werden:

500 kVA / Faktor 254 ( Strom-/Zeitverhältnis) = 1,96 kVA

Es wird anhand der Berechnungen bzw. Abschätzungen ein Transformator mit einer Leistungsaufnahme von < 2 kVA gewählt, (z.B. Kernpaketabmessung von 135 mm * 135 mm aus der üblichen Typenliste).

An die Transformatorwicklungen sind, wenn die Meßfehler < 10 % bleiben sollen, folgende Anforderungen zu stellen:

a) im Kurzschlußfall:
Der Gleichstromwiderstand der Eingangswicklung muß im Kurzschlußfall kleiner als $\frac{Ri}{10}$ sein, um die Übertragung des Kurzschlußstromes mit mindestens 90 % sicher zu stellen. Der Ri des Impulsgenerators beträgt 2 Ω, d. h. der Gleichstromwiderstand der Eingangswicklung darf höchstens 200 mΩ betragen.

b) im Leerlauf:
Im Leerlauf muß die Impedanz der Eingangswicklung mindestens > 10 * Ri bei der 1. Grundwelle des Impulses der Dauer von 1,2/50 μs betragen. Dadurch wird ebenfalls sichergestellt, daß im Leerlauf mindestens 90 % der Impulsspannung übertragen werden. Der Ri des Impulsgenerators beträgt 2 Ω, d.h. die Impedanz der Eingangswicklung muß mindestens 20 Ω betragen.

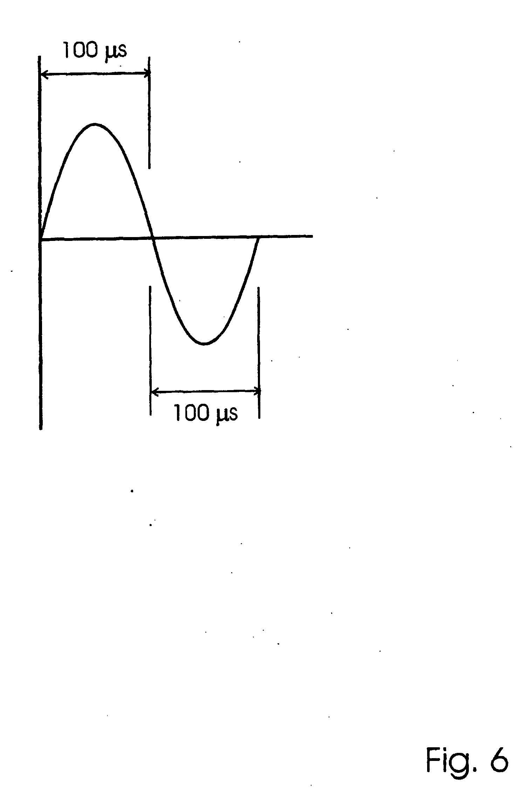

Die Abschätzung der Grundfrequenz erfolgt, entsprechend Fig. 6, auf:

$$f = \frac{1}{t} = \frac{1}{200\mu s} = 5 \text{ kHz.}$$

Bei dieser Frequenz ist die Schirmwirkung eines Metallgeflechtes noch sehr gering, so daß ein großer Teil der Leistung in die Innenleiter eingekoppelt wird.

Der Scheinwiderstand Z muß bei 5 kHz muß > 20 Ω sein. Entscheidend für Z ist hierbei überwiegend der Blindwiderstand $X_L$ der Wicklung, da der

Gleichstromwiderstand Ra < $\frac{Ri}{10}$, d.h. < 0,2 Ω ist.

Wenn die Impedanz einer Einzelwindung ermittelt wurde, wird ersichtlich daß ca. 10 Windungen notwendig sind um die geforderte Impedanz von > 20 Ω bei 5 kHz zu erreichen. Der Gleichstromwiderstand beträgt ca. 60 mΩ und entspricht somit der Forderung < $\frac{Ri}{10}$.

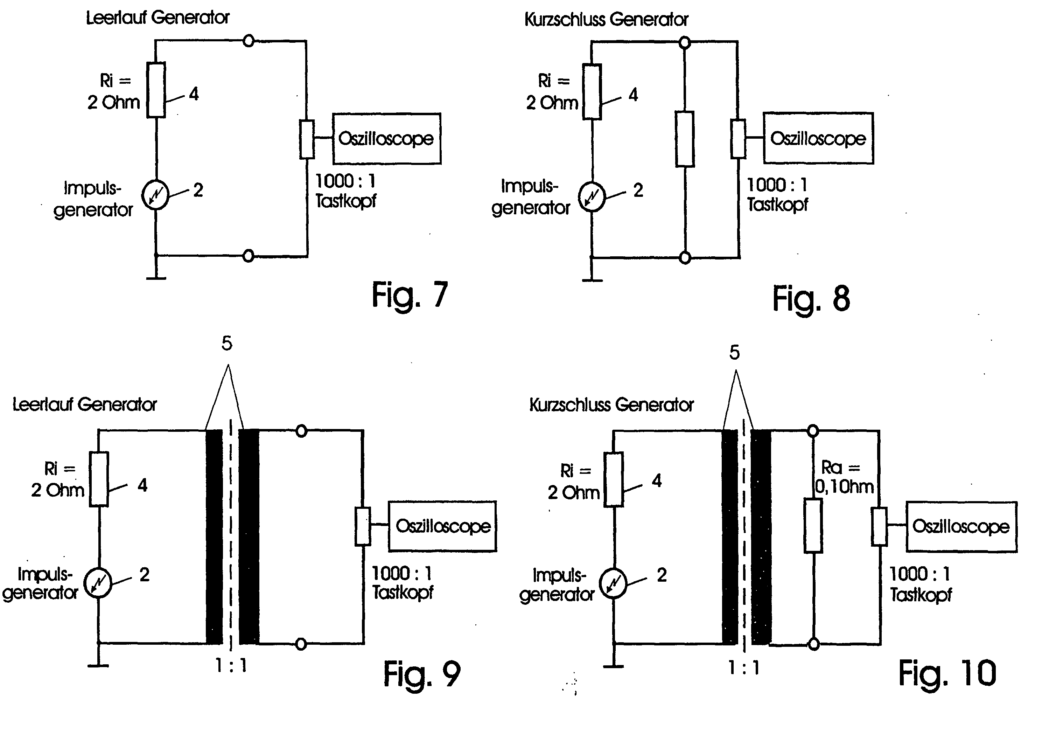

Eine Überprüfung der Impulsübertragung bei verschiedenen Belastungsfällen ist mit Meßaufbauten entsprechend der Figuren 7 bis 10, und zwar hinsichtlich Leerlauf Generator entsprechend Fig. 7, hinsichtlich Kurzschluß Generator entsprechend Fig. 8, hinsichtlich Leerlauf Transformator entsprechend Fig. 9 und hinsichtlich Kurzschluß Transformator entsprechend Fig. 10, jeweils mit Impulsgenerator 2 mit Innenwiderstand 4 möglich. Dabei ist aber zu beachten, daß der Transformator 5 bei den Messungen nicht in die Sättigung gebracht werden darf, da sonst keine Übertragung des Impulses mehr stattfinden kann.

Die Auswertung der Meßergebnisse zeigt, daß wie gefordert mindestens 90 % der Generatorspannung im Leerlauf des Transformators übertragen werden. Die auftretenden Verluste sind erklärbar mit den Übertragungsverlusten des Transformators. Eine zeitliche Verfälschung der Impulsform findet nicht statt.

Im Kurzschlußfall wird der Strom nur zu ca. 50 % übertragen. Weiterhin sind Anderungen im Zeitverhalten feststellbar. Dieses ist in dem höheren Gleichstromwiderstand des verwendeten Kabels für die Sekundärwicklung begründet.

In Abhängigkeit der zu beeinflussenden geschirmten Leitung können somit Änderungen des Stromes im Kurzschlußfall auftreten. Dieses Phänomen wird auch bei einer realen Installation auftreten.

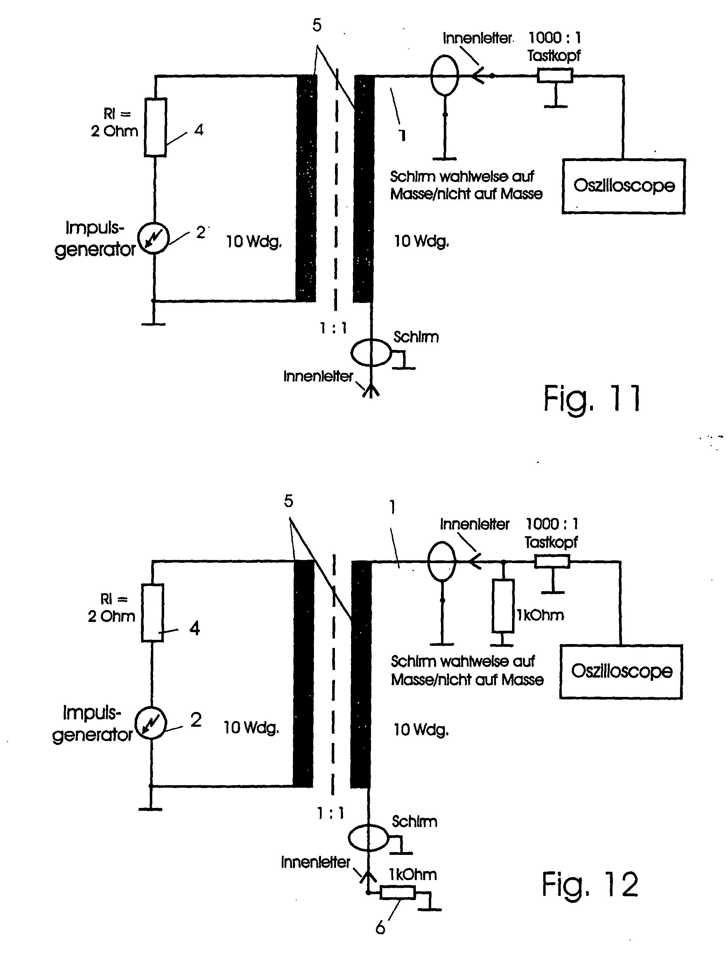

Meßaufbauten zur Ermittlung der Impulsspannungen auf dem Innenleiter der Sekundärwicklung sind aus Fig. 11 ohne und aus Fig. 12 mit Abschlußwiderstand 6 ersichtlich. Im Falle einer schlechten bzw. nicht vorhandenen Schirmkontaktierung wird an der Meßobjektseite nahezu die gesamte Impulsspannung auf die Innenleiter der geschirmten Leitung induziert. Dies gilt sowohl für den Fall, daß der Innenleiter eine Impedanz von Z = ∞ aufweist, als auch für den Fall, daß Z = 1 kΩ beträgt.

Im Falle einer Kontaktierung des Schirms der Meßobjektseite gegen Masse wird auf die Innenleiter nur eine Spannung von ca. 35 V induziert. Meßobjekte mit einer nicht vorhandenen Schirmkontaktierung gegen Masse an der Meßobjektseite, sind somit bei der Beeinflussung mit Impulsen der Form 1,2/50 µs wesentlich stärker gefährdet, als Meßobjekte bei denen der Schirm der Leitung an beiden Seiten gegen Masse kontaktiert ist.

## Patentansprüche

1. Verfahren zur Messung der Elektromagnetischen Verträglichkeit, bei dem, entsprechend der Europäischen Norm ENV 50142, Verbindungsleitungen (1) von einem Hybrid-Prüfgenerator (2) mit potentialfreiem Ausgang über wenigstens einen Prüfling (EUT) mit Spannungs- bzw. Stromimpulsen beaufschlagt werden, deren Auswirkung auf die Verbindungsleitungen bzw. Schutzgeräte über eine Entkopplung ausgewertet werden, **dadurch gekennzeichnet, daß**, zur Verminderung des Spannungspotentials bei gleichzeitig vergrößerter Beeinflussung der Verbindungsleitungen (1), eine auf die Impulsform abgestimmte transformatorische Entkopplung des Hybrid-Prüfgenerators (2) von dem bzw. den Prüflingen (EUT), den Verbindungsleitungen (1) und Schutz- und Auswertegeräten (3) vorgenommen wird.

2. Vorrichtung zur Messung der Elektromagnetischen Verträglichkeit, bestehend, entsprechend der Europäischen Norm ENV 50142, aus einem Hybrid-Prüfgenerator (2) mit definiertem Innenwiderstand und einer Meßanordnung mit wenigstens einem Prüfling, einer Verbindungsleitung (1) und einem Auswertegerät, **dadurch gekennzeichnet, daß** zwischen dem Hybrid- Prüfgenerator (2) mit Innenwiderstand (4) und der gesamten Meßanordnung ein Impulstransformator (5) eingeschaltet ist, der neben der galvanischen Trennung, eine definierte Impedanz für die Impulse des Prüfgenerators (2) und geringen Gleichstromwiderstand aufweist.

## Claims

1. Process for measuring electromagnetic compatibility, wherein, according to European standard ENV 50142, voltage/current pulses are applied via at least one object under test (EUT) to connecting leads (1) of a hybrid test generator (2) with isolated output, the effect of said pulses on the connecting leads/protection devices being evaluated via decoupling, **characterized in that,** in order to reduce the voltage potential with simultaneously increased influencing of the connecting leads (1), there is transformer decoupling, matched to the pulse shape, of the hybrid test generator (2) from the object(s) under test (EUT), from the connecting leads (1) and from protection and evaluations devices (3).

2. Device for measuring electromagnetic compatibility, consisting, according to European standard ENV 50142, of a hybrid test generator (2) with defined internal resistance and of a measuring arrangement with at least one object under test, a connecting lead (1) and an evaluation device, **characterized in that** connected between the hybrid test generator (2) with internal resistance (4) and the entire measuring arrangement is a pulse transformer (5) which, apart from electrical isolation, has a defined impedance for the pulses of the test generator (2) and low ohmic resistance.

**Revendications**

1.  Procédé de mesure de la compatibilité électromagnétique dans lequel, conformément à la norme européenne ENV 50142, des impulsions de tension ou de courant sont appliquées sur des lignes de connexion (1) par un générateur d'essais hybride (2) avec sortie sans potentiel sur au moins un échantillon (EUT), les répercussions de ces impulsions sur les lignes de connexion ou les équipements de protection étant analysées au moyen d'un découplage,

    **caractérisé en ce que,** pour réduire le potentiel de tension tout en augmentant l'impact sur les lignes de connexion (1), le générateur d'essais hybride (2) est découplé du/des échantillon(s) (EUT), des lignes de connexion (1) et des équipements de protection et d'analyse (3) d'une manière adaptée à la forme d'impulsion.

2.  Dispositif de mesure de la compatibilité électromagnétique constitué, conformément à la norme européenne ENV 50142, d'un générateur d'essais hybride (2) avec résistance intérieure définie et montage de mesure avec au moins un échantillon, d'une ligne de connexion (1) et d'un équipement d'analyse, **caractérisé en ce qu'**un transformateur d'impulsions (5) est inséré entre le générateur d'essais hybride (2) avec résistance intérieure (4) et l'ensemble du montage de mesure, ce transformateur présentant, outre la séparation galvanique, une impédance définie pour les impulsions du générateur d'essais (2) et une faible résistance ohmique.

5   1   EUT

Ri =
2 Ohm   4

10 Wdg.   10 Wdg.   Ri/Z

Impulsgenerator   2

1 : 1

Schirm

Oszilloscope

1000 : 1
Tastkopf

Objektraum
Meßraum

Filter

Simulator
(Endgerät)   3

Netzspannung

Fig. 2

Impuls

Fig. 3

Fig. 4

Fig. 5

100 μs

100 μs

Fig. 6

**Fig. 7**

Leerlauf Generator

Oszilloscope

1000 : 1
Tastkopf

Ri =
2 Ohm

4

Impulsgenerator

2

**Fig. 8**

Kurzschluss Generator

Oszilloscope

1000 : 1
Tastkopf

Ri =
2 Ohm

4

Impulsgenerator

2

**Fig. 9**

Leerlauf Generator

Oszilloscope

1000 : 1
Tastkopf

Ri =
2 Ohm

4

Impulsgenerator

2

5

1 : 1

**Fig. 10**

Kurzschluss Generator

Oszilloscope

1000 : 1
Tastkopf

Ra =
0,1 Ohm

Ri =
2 Ohm

4

Impulsgenerator

2

5

1 : 1

Fig. 11

Fig. 12